# EUROPÄISCHE PATENTSCHRIFT

(11) **EP 0 270 802 B1**
(45) Veröffentlichungstag und Bekanntmachung des Hinweises auf die Patenterteilung: **27.01.1993**
(21) Anmeldenummer: 87115714.5
(22) Anmeldetag: 27.10.1987
(51) Int. Cl.: G01R 11/24, G01F 15/00, G09F 3/03

(54) **Einrichtung zum Plombieren und gleichzeitigen mechanischen Verriegeln eines Deckels an einem Gerät**
Device for sealing and simultaneously mechanically locking a cover onto an apparatus
Dispositif pour sceller et simultanément verrouiller mécaniquement un couvercle sur un appareil

(30) Priorität: 20.11.1986 DE 3639670
(43) Veröffentlichungstag der Anmeldung: 15.06.1988
(73) Patentinhaber: EFEN Elektrotechnische Fabrik GmbH, D-65332 Eltville (DE)
(72) Erfinder: Fillbach, Jürgen, D-6251 Hahnstätten (DE); Kilian, Francis, D-6222 Geisenheim (DE); Stolper, Gottfried, D-6227 Oestrich-Winkel (DE)
(74) Vertreter: Weber, Dieter, Dr.

(56) Entgegenhaltungen:
- DE-A- 1 465 530
- DE-B- 1 036 376
- DE-U- 8 614 530
- US-A- 1 403 604

## Beschreibung

Die Erfindung betrifft eine Einrichtung zum Plombieren und gleichzeitigen mechanischen Verriegeln eines Deckels am Gestell eines Gerätes, insbesondere eines NH-Sicherungstrenners, NH-Sicherungsunterteiles oder einer NH-Sicherungsschaltleiste, wobei bei dieser Einrichtung ein im Loch eines großen Arretiersteges gegenüber dem Deckel verschiebbar geführter Plombierstift, der an seinem einen Ende einen Flansch aufweist, in das Loch einer am Gerätegestell befestigten Plombierlasche einsteckbar ist und einen Durchmesser hat, der kleiner ist als die Länge des Flansches.

Geräte der vorstehenden Art sind häufig um Zähler herum angeordnet, weil der Wunsch besteht, den Deckel derartiger Geräte vom Laien oder auch von anderen Endverbrauchern nicht ohne weiteres öffnen zu lassen. In jedem Wohnhaus sind elektrische Geräte angebracht, deren Deckel plombiert sind.

Bekannt sind aber auch NH-Sicherungstrenner oder NH-Sicherungsuntersteile, bei denen am Gestell eine Plombierlasche befestigt ist, die in den Deckel hineinragt und über ein Loch mittels eines Plombierdrahtes gegen unerwünschtes Öffnen gesichert ist.

Es bestand auch schon der Wunsch nach einer Plombierung und gleichzeitigen mechanischen Sicherung eines Deckels an einem elektrischen Gerät, um ein versehentliches Öffnen mechanisch zu verhindern. Derartige Geräte sind mit einem am Deckel verschiebbar geführten Plombierstift versehen, in dessen einem Ende ein kleines Loch zum Durchstecken des Plombierdrahtes angeordnet ist. Der Plombierstift mit an einer Seite angebrachtem Flansch sorgt für die Festlegung der am Gerätegestell befestigten Plombierlasche an einem großen Arretiersteg am Deckel, kann aber nach Entfernen des Plombierdrahtes herausgezogen und beiseitegelegt werden.

Bei der Benutzung, Wartung oder dergleichen wird der Stift im bekannten Fall beim Öffnen entnommen und geht in nachteiliger Weise häufig verloren. Der Benutzer versucht dann, den Plombierdraht gleichzeitig als mechanische Sicherung einzusetzen, weil er beispielsweise den Plombierstift nicht mehr wiederfindet.

Deshalb ist es Aufgabe der vorliegenden Erfindung, die Einrichtung zum Plombieren der vorstehend genannten Art so zu verbessern, daß der Plombierstift und die anderen Teile der Einrichtung unverlierbar sind, sogar nach dem Entriegeln, und daß der Plombierstift so angebracht ist, daß er nicht selbständig in die Verriegelungsstellung gelangen kann.

Diese Aufgabe wird gemäß der Erfindung dadurch gelöst, daß eine erste und eine zweite Rastnase am Deckel, in einem lichten ersten Abstand in Richtung der Längsachse des Plombierstiftes voneinander angebracht sind, daß der in Querrichtung zur Längsachse des Plombierstiftes gemessene Querabstand dieser Rastnasen kleiner als die Länge des Flansches ist, daß der lichte erste Abstand größer oder gleich der Dicke des Flansches ist, und daß der lichte zweite Abstand der weiter vom großen Arretiersteg entfernten zweiten Rastnase von dem großen Arretiersteg kleiner oder gleich der Länge des Plombierstiftes ist.

Durch diese Ausgestaltung des Plombierstiftes mit Flansch und Anordnung zweier Rastnasen im Verhältnis zum großen Arretiersteg ist erreicht, daß der Plombierstift mit seinem Flansch sowohl in der entriegelten als auch in der verriegelten Position unverlierbar am Deckel angeordnet ist, und zusätzlich derart, daß er von selbst nicht in die Verriegelungsstellung gelangen kann. Der eine, in Längsrichtung des Plombierstiftes von der Rastnase weiter entfernt angeordnete "große" Arretiersteg ragt von einer Seite der Griffmulde im Deckel weiter in Richtung quer zu der genannten Längsrichtung, vorzugsweise sogar bis zur gegenüberliegenden Seite der Griffmulde, als ein anderer, sogenannter "kleiner" Arretiersteg, der nachfolgend noch erwähnt wird. Von der Seite der Griffmulde in der genannten Querrichtung ragt also der größere Arretiersteg bis in den Bereich der genannten Längsachse des Plombierstiftes, während der kleinere Arretiersteg diesen Bereich nicht einmal erreicht.

Der am einen Ende des Plombierstiftes angebrachte Flansch wird im entriegelten Zustand
zwischen den zwei Rastnasen gehalten, und im verriegelten Zustand wird er zwischen der ersten Rastnase, welche dem großen Arretiersteg am nächsten liegt, und der der ersten Rastnase zugewandten Fläche des großen Arretiersteges gehalten. Das dem Flansch gegenüberliegende Ende des Plombierstiftes wird im entriegelten Zustand im Loch des großen Arretiersteges, welches auch auf einer Seite in einen Schlitz übergehen kann, gehalten und im verriegelten Zustand durch das in Flucht dazu befindliche Loch der am Gestell befestigten Plombierlasche gesteckt und dort gehalten. Hierdurch ergibt sich die Unverlierbarkeit, auch nach dem Entriegeln. Die erste Rastnase hat eine dem großen Arretiersteg abgewandte Fläche, die im entriegelten Zustand dafür sorgt, daß der Plombierstift nicht in das Loch der am Gestell befestigten Plombierlasche geraten kann und sich dadurch von allein verriegelt. Mit anderen Worten, die Höhe der Rastnasen muß so ausgebildet sein, daß auch bei grötem Spiel der Flansch form- und kraftschlüssig zwischen beiden gehalten wird. Der Flansch des Plombierstiftes kann nämlich aus dem entriegelten Zustand nicht ohne Überwindung einer gewissen Schwellenkraft über die erste Rastnase hinüßergelangen. Diese Rastnase bietet daher eine Selbsthemmung für den Flansch mit angebrachtem Plombierstift. Die zweite Rastnase dient der Unverlierbarkeit und ist in einem solchen Abstand von der ersten Rastnase angeordnet, daß sich der Flansch stets dazwischen anordnen läßt.

Die Rastnasen können als aus einer Fläche herausragende Halbkugeln ausgestaltet sein oder auf andere Weise Anlaufschrägen aufweisen, so daß nach Überwindung der genannten Schwellenkraft der Plombierstift mit Flansch in die Verriegelungsposition, die Entriegelungsstellung geschoben oder auch ganz herausgenommen werden kann. Stets ist hierzu aber eine gewisse Kraftschwelle zu überwinden, so daß der Benutzer diese Bewegungen stets bewußt ausführt und dadurch mit Vorteil auch durch das Entriegeln der Plombierstift nicht ohne weiteres verlorengehen kann.

Zweckmäßig ist es auch, wenn bei weiterer Ausgestaltung der Erfindung der in Querrichtung zur Längsachse des Plombierstiftes gemessene Querabstand zwischen der ersten und der zweiten Rastnase maximal annähernd gleich der Länge des Flansches ist. Bei einer ersten Ausführungsform kann dieser Querabstand zu Null werden, wenn nämlich beide Rastnasen in Richtung der Längsachse des Plombierstiftes in Flucht hintereinander liegen. Bei einer anderen Ausgestaltung hingegen können sie seitlich um den Querabstand versetzt sein, nämlich quer zur Längsrichtung des Plombierstiftes.

Ein weiterer Vorteil der erfindungsgemäßen Plombier- und Verriegelungseinrichtung ist die günstige Nachrüstbarkeit, ohne daß man am Deckel, am Gestell oder am Plombierstift besondere Nacharbeiten zu leisten hätte.

Bei vorteilhafter weiterer Ausgestaltung der Erfindung ist in einer zur Hauptebene des großen Arretierstiftes parallelen, in Richtung auf die erste Rastnase hin verschobenen Ebene ein kleiner Arretiersteg in einem lichten dritten Abstand vom großen Arretiersteg angeordnet und am Deckel befestigt, ist der lichte dritte Abstand mindestens gleich der Dicke des Flansches, und ist vorzugsweise in beiden Arretierstegen je ein Loch in Flucht zum anderen angebracht, wobei ein weiteres, im Flansch des Plombierstiftes vorhandenes Loch mit diesen Löchern in Flucht liegend einstellbar ist. Der Durchmesser der drei vorstehend erwähnten Löcher kann kleiner ausgebildet sein als der Durchmesser in der am Gestell befestigten Plombierlasche; denn diese drei in Flucht ausrichtbaren Löcher dienen dem Hindurchstecken des Plombierdrahtes, wodurch der Plombierstift in der gewünschten Position festgelegt werden kann. Der Flansch am Plombierstift weist im Abstand von der Achse des Plombierstiftes ein einziges Loch auf, welches je nach Drehung oder Verschiebung des Flansches mit den deckelseitig festen Löchern in den Arretierstegen in Flucht gebracht werden kann.

Der große Arretiersteg kann ein Vorsprung oder Ansatz sein oder einstückig mit dem Deckel ausgebildet, an diesem angeschweißt, angeschraubt oder angeformt sein. Das gleiche gilt für den kleinen Arretiersteg, der zweckmäßig in Längsrichtung des Plombierstiftes gesehen in einem solchen lichten Abstand vom großen Arretiersteg angeordnet ist, daß der Flansch mit seiner Dicke dazwischen angeordnet werden kann. Sinn und Zweck des kleinen Arretiersteges ist es, Kräfte aufzufangen, die auf den Plombierstift und damit aus den Flansch beispielsweise durch seitlichen Druck oder durch Rütteln aufgebracht werden, z. B. durch einen Brumm von 50 Hz bei den eingangs erwähnten elektrischen Geräten. Dadurch ist sichergestellt, daß der Plombierstift nicht aus einer Verriegelungsposition herausgelangen kann.

Zweckmäßig ist es ferner, wenn die Arretierstege, der Plombierstift, der Flansch und die Plombierlasche des Gerätegestelles im wesentlichen in einer Vertiefung im Deckel angeordnet sind. Beispielsweise kann es sich um eine in Richtung des Plombierstiftes im Deckel angeordnete längliche Vertiefung, vorzugsweise um eine Griffmulde, handeln, die in Richtung quer zur Längsachse des Plombierstiftes so groß ausgebildet sein sollte, daß der Flansch des Plombierstiftes zumindest im verriegelten Zustand im wesentlichen in der Mulde oder Vertiefung liegt. Dadurch liegt die gesamte Verriegelungsanordnung innerhalb der Frontebenen der Geräte und stört nicht bei der Handhabung, z. B. beim Schließen. Dadurch ist auch die Verletzungsgefahr für die Benutzer ausgeschlossen. Ein weiterer Vorteil einer solchen Vertiefung, z. B. als Griffmulde, besteht darin, daß die Baubreite des betreffenden Gerätes von der Plombier- und Verriegelungseinrichtung unabhängig ist. Man kann mit Vorteil derartige Geräte dicht an dicht nebeneinander anordnen und dennoch die Plombierung und auch Verriegelung lösen; denn man braucht hierzu nicht etwa von der Seite an das Geräte oder den Deckel heranzugehen, um Eingriffe etwa von der Seite vorzunehmen.

Günstig ist es gemäß einer Weiterbildung der Erfindung aber auch, wenn der Flansch exzentrisch am Plombierstift befestigt und vorzugsweise länglich ausgebildet ist. Die Ausgestaltung des Flansches als Exzenter erlaubt in besonders günstiger Weise das Versenken aller Teile der Plombier- und Verriegelungseinrichtung in der vorgenannten Griffmulde. Außerdem erlaubt der Exzenter das Einstellen einer definierten Position, in welcher beispielsweise das Loch im Flansch mit den beiden Löchern in den Arretierstegen in Flucht liegt, so daß der Plombierdraht durch alle drei in Flucht zueinander befindliche Löcher gesteckt werden kann.

Vorteilhaft ist es, wenn gemäß einer Weiterbildung der Erfindung der exzentrische Flansch eine Anschlagfläche für den Eingriff mit einer Oberfläche der Vertiefung aufweist. Diese Anschlagfläche liegt vorzugsweise aus dem Umfang des Flansches an derjenige Stelle, die beim Hereindrehen in die Verriegelungsstellung gegen den Grund der Vertiefung anläuft. Damit gelangt der Extenter (als Flansch) in die richtige Position, so daß die vorgenannten drei Löcher wieder richtig in Flucht einstellbar sind, und zwar ohne Justierarbeiten, vielmehr einfach durch Hereindrehen und Festdrücken.

Da bei exzentrischer Ausgestaltung des Flansches dieser zumindest in der Verriegelungsposition in der Vertiefung hinter die Frontebene des Deckels zu liegen kommt, ist es vorteilhaft, wenn zum besseren Ergreifen mittels eines Werkzeuges und Herausdrehen in eine andere Position, z. B. zum Entriegeln, der exzentrische Flansch eine in versenkter Stellung dem Betrachter zugewandte Hinterschneidung oder Nut aufweist.

Günstig ist es auch, wenn der exzentrische Flansch eine Riffelung hat, die nach dem teilweisen Herausdrehen des Flansches durch Aufbringen eines kleinen Drehmomentes mittels des Werkzeuges über die Hinterschneidung oder Nut dem Benutzer die Möglichkeit gibt, durch Ergreifen den Flansch in die Öffnungsstellung zu drehen. In dieser kann der Benutzer dann einfach Seitenkräfte (die oben genannte Schwellenkraft) aufbringen, um den Flansch mit Plombierstift in die Entriegelungs- oder Verriegelungsstellung zu bringen. Wenn die gewünschte Position erreicht ist, wird der Flansch wieder in die Vertiefung oder Griffmulde hineingedreht, damit die übrige Handhabung des Deckels oder des gesamten elektrischen Gerätes nicht durch die Plombier- und Verriegelunaseinrichtung beeinträchtigt wird. Weitere Vorteile, Merkmale und Anwendungsmöglichkeiten der vorliegenden Erfindung ergeben sich aus der folgenden Beschreibung eines bevorzugten Ausführungsbeispieles in Verbindung mit der folgenden Beschreibung. Es zeigen
- Fig. 1: eine abgebrochene Draufsicht aus den Deckel eines NH-Sicherungsunterteiles mit der erfindungsgemäßen Einrichtung zum Plombieren und mechanischen Verriegeln in der geöffneten Stellung,
- Fig. 2: die gleiche Ansicht wie Fig. 1, wobei jedoch der Plombierstift mit Flansch in der Verriegelungsstellung gezeigt ist, und
- Fig. 3: eine ebenfalls abgebrochene Schnittansicht durch den Flansch mit zwei verschiedenen Positionen.

Von dem NH-Sicherungsunterteil ist nur der Deckel 1 mit der länglichen Griffmulde 2 und einer Öffnung 3 gezeigt, durch welche die am Gerätegestell befestigte Plombierlasche 4 strichpunktiert hindurchragend zu sehen ist.

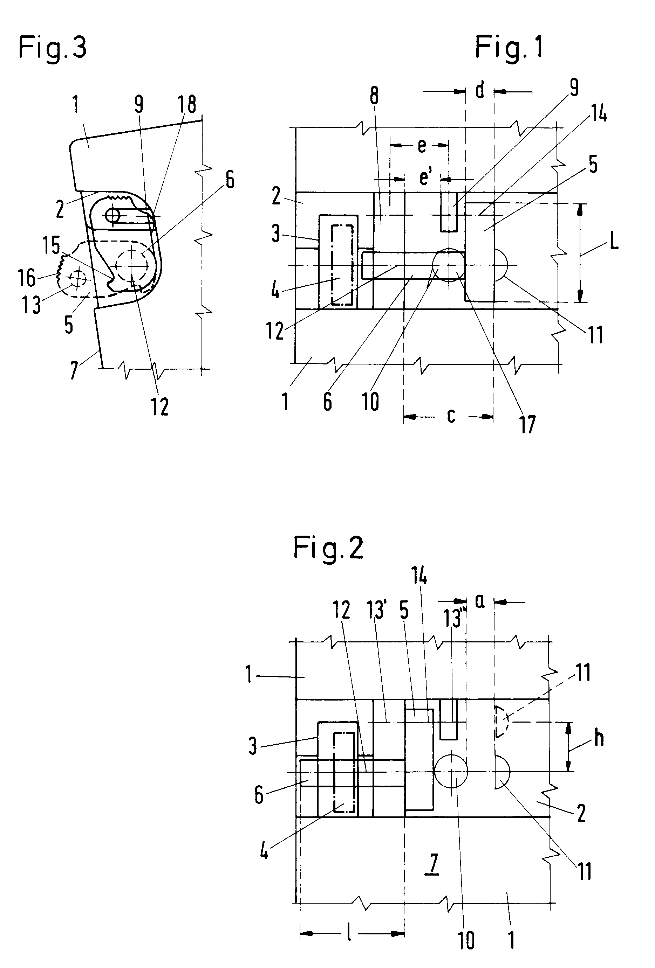

In Fig. 3 sieht man deutlich, wie in der einen oder anderen verrasteten Position der Flansch 5 am Plombierstift 6 hinter der Frontebene 7 des Deckels 1 vollständig in der Griffmulde oder Vertiefung 2 angeordnet ist.

Da der Deckel 1 aus Kunststoff geformt ist, sind sowohl der große Arretiersteg 8 als auch der kleine Arretiersteg 9 angeformt und befinden sich hinter dieser Frontebene 7 vollständig in der Griffmulde 2. Der Mittenabstand des kleinen Arretiersteges 9 vom großen Arretiersteg 8 ist in Fig. 1 mit e bezeichnet; die Dicke des Flansches 5 mit d, seine Länge mit L.

Eine erste Rastnase 10 und eine zweite Rastnase 11 liegen bei der hier gezeigten Auführungsform in Flucht hintereinander in Richtung der Längsachse 12 des Plombierstiftes 6. Der lichte Abstand der ersten Rastnase 10 von der zweiten Rastnase 11 ist in Fig. 2 mit a bezeichnet; der lichte Abstand zwischen der zweiten Rastnase 11 und dem großen Arretiersteg 8 in Fig. 1 ist mit c bezeichnet.

Bei einem anderen hier nur gestrichelt dargestellten Ausführungsbeispiel gemäß Fig. 2 kann die zweite Rastnase 11 in einem Querabstand h von der Längs- bzw. Drehachse 12 und mithin der Mitte der ersten Rastnase 10 angeordnet sein.

In Fig. 3 ist die besondere Ausgestaltung des Flansches 5 als Exzenter dargestellt, der länglich ausgebildet ist. Man erkennt die Längs- bzw. Drehachse 12 im Kreuz des gestrichelt angedeuteten Plombierstiftes 6, wobei die versenkte Position des Flansches 5 die mit ausgezogenen Linien gezeigte und die Betätigungsposition die gestrichelt gezeigte Stellung ist. Im Abstand von der Drehachse 12 ist im Flansch 5 ein Loch 13 vorgesehen, welches kleiner als der Außendurchmesser des Plombierstiftes 6 ist; denn dieses Loch 13 dient lediglich dem Durchstecken eines hier nicht gezeigten Plombierdrahtes.

In der Position der Fig. 2 befindet sich dieses Loch 13 im Flansch 5 auf der strichpunktierten Linie 14, welche die Mitte des Loches 13 im Flansch 5 und auch die Mitte von in Flucht dazu befindlichen Löchern 13' im großen Arretiersteg 8 und 13'' im kleinen Arretiersteg 9 darstellen soll.

Im Betrieb wird davon ausgegangen, daß die Einrichtung durch Nachrüsten an ein NH-Sicherungsunterteil angebracht worden ist und sich zunächst in der entriegelten Position gemäß Fig. 1 und 3 (mit ausgezogenen Linien) befindet.

Der Benutzer versorgt das Gerät, schließt den Deckel 1 und betätigt nun die Plombier- und Verriegelungseinrichtung. Er setzt ein Werkzeug in der Hinterschneidung oder Nut 15 an, wodurch sich der Flansch 5 gemäß Fig. 3 ein Stück weit um einen Winkel von 20 bis 60°, vorzugsweise 45°, aus der mit ausgezogenen Linien dargestellten Position im Gegenuhrzeigersinn herausdreht. Der Benutzer kann nun mit einem Finger leicht auf die Riffelung 16 fassen und den Flansch 5 in die in Fig. 3 mit gestrichelten Linien gezeigte Position herausdrehen.

Nun bringt der Benutzer seitliche Kräfte in Richtung der Längsachse 12 des Plombierstiftes 6 auf den Flansch 5 auf und bewegt diesen hierdurch über die rechte Anlauffläche 17 der ersten Rastnase 10, wobei für die Darstellung der Fig. 1 zu beachten ist, daß der Flansch 5 ohne weiteres an dem kleinen Arretiersteg 9 vorbeibewegbar ist; denn sein oberes Ende mit der Riffelung 16 ist aus der Griffmulde 2 herausgedreht. Durch seitlichen Druck von rechts nach links in Richtung Plombierstift 6 bewegt sich dieser in ein nicht dargestelltes Loch in der Plombierlasche 4 und gelangt in die in Fig. 2 dargestellte Verriegelungsposition, wobei der Flansch 5 über die erste Rastnase 10 hinübergedrückt worden ist und nun an der der Auflaufschräge 17 gegenüberliegenden Schräge der ersten Rastnase 10 anliegt. Sodann wird der exzentrische Flansch 5 durch Fingerdruck aus der in Fig. 3 gestrichelt gezeichneten Position im Uhrzeigersinn in die mit ausgezogenen Linien gezeigte Position so weit gedrückt, bis die Anschlagfläche 18 des Flansches 5 gegen die entsprechend gegenüberliegende Oberfläche der Griffmulde 2 in Eingriff bzw. Anlage kommt derart, daß eine feste Position des Flansches 5 gemäß Darstellung der Fig. 1 bis 3 erreicht ist. Nun ist die Verriegelungsstellung der Fig. 2 erreicht, bei welcher gleichzeitig auch die Löcher 13, 13' und 13'' in Flucht zueinander liegen, so daß der Benutzer den Plombierdraht einführen und die Einrichtung verplomben kann.

Die Länge 1 des Plombierstiftes 6 ist so bemessen, daß er sowohl in der Verriegelungsstellung der Fig. 2 als auch der Entriegelungsstellung der Fig. 1 stets von dem großen Arretiersteg 8 gehalten wird bzw. durch das in ihm befindliche Loch hindurchgeführt ist.

## Patentansprüche

1. Einrichtung zum Plombieren und gleichzeitigen mechanischen Verriegeln eines Deckels (1) am Gestell eines Gerätes, insbesondere eines NH-Sicherungstrenners, NH-Sicherungsunterteiles oder einer NH-Sicherungsschaltleiste, wobei bei dieser Einrichtung ein im Loch eines großen Arretiersteges (8) gegenüber dem Deckel (1) verschiebbar geführter Plombierstift (6), der an seinem einen Ende einen Flansch (5) aufweist, in das Loch einer am Gerätegestell befestigten Plombierlasche (4) einsteckbar ist und einen Durchmesser hat, der kleiner ist als die Länge (L) des Flansches (5), dadurch gekennzeichnet, daß eine erste und eine zweite Rastnase (10, 11) am Deckel (1), in einem lichten ersten Abstand (a) in Richtung der Längsachse (12) des Plombierstiftes (6) voneinander angebracht sind, daß der in Querrichtung zur Längsachse (12) des Plombierstiftes (6) gemessene Querabstand (h) dieser Rastnasen (10, 11) kleiner als die Länge (L) des Flansches (5) ist, daß der lichte erste Abstand (a) größer oder gleich der Dicke (d) des Flansches (5) ist, und daß der lichte zweite Abstand (c) der weiter vom großen Arretiersteg (8) entfernten zweiten Rastnase von dem großen Arretiersteg (8) kleiner oder gleich der Länge (l) des Plombierstiftes (6) ist.

2. Einrichtung nach Anspruch 1, dadurch gekennzeichnet, daß der in Querrichtung zur Längsachse (12) des Plombierstiftes (6) gemessene Querabstand (h) zwischen der ersten (10) und der zweiten Rastnase (11) maximal annähernd gleich der Länge (L) des Flansches (5) ist.

3. Einrichtung nach Anspruch 1 oder 2, dadurch gekennzeichnet, daß in einer zur Hauptebene des großen Arretierstiftes (8) parallelen, in Richtung auf die erste Rastnase (10) hin verschobenen Ebene ein kleiner Arretiersteg (9) in einem lichten dritten Abstand (e') vom großen Arretiersteg (8) angeordnet und am Deckel (1) befestigt ist, daß lichte dritte Abstand (e') mindestens gleich der Dicke (d) des Flansches (5) ist, und daß vorzugsweise in beiden Arretierstegen (8, 9) je ein Loch (13', 13'') in Flucht zum anderen angebracht ist, wobei ein weiteres, im Flansch (5) des Plombierstiftes (6) vorhandenes Loch (13) mit diesen Löchern (13', 13'') in Flucht liegend einstellbar ist.

4. Einrichtung nach einem der Ansprüche 1 bis 3, dadurch gekennzeichnet, daß die Arretierstege (8, 9), der Plombierstift (6), der Flansch (5) und die Plombierlasche (4) des Gerätegestelles im wesentlichen in einer Vertiefung (2) im Deckel (1) angeordnet sind.

5. Einrichtung nach einem der Ansprüche 1 bis 4, **dadurch gekennzeichnet**, daß der Flansch (5) exzentrisch am Plombierstift (6) befestigt und vorzugsweise länglich ausgebildet ist.

6. Einrichtung nach Anspruch 5, **dadurch gekennzeichnet**, daß der exzentrische Flansch (5) eine Anschlagfläche (18) für den Eingriff mit einer Oberfläche der Vertiefung (2) aufweist.

7. Einrichtung nach Anspruch 5 oder 6, **dadurch gekennzeichnet**, daß der exzentrische Flansch (5) eine in versenkter Stellung dem Betrachter zugewandte Hinterschneidung oder Nut (15) oder andere Eingriffsmöglichkeit für ein Werkzeug aufweist.

8. Einrichtung nach einem der Ansprüche 5 bis 7, **dadurch gekennzeichnet**, daß der exzentrische Flansch (5) eine Riffelung (16) oder andere Oberflächenrauhigkeit aufweist.

9. Einrichtung nach einem der Ansprüche 1 bis 8, **dadurch gekennzeichnet**, daß der lichte vierte Abstand zwischen dem großen Arretiersteg (8) und der nächstliegenden Rastnase (10) größer als die Dicke (d) des Flansches (5) ist.

## Claims

1. A means of applying a lead seal to and at the same time mechanically locking a cover (1) on the frame of an appliance, particularly of an NH fused isolator, the bottom of an NH fuse or an NH fuse connector strip, the said means comprising, guided for displacement in relation to the cover (1) and in a hole in a large locking web (8), a lead sealing pin (6) which has a flange (5) at one end, is adapted for insertion into a hole in a lead sealing lug (4) fixed to the appliance frame and has a diameter which is smaller than the length (L) of the flange (5), characterised in that first and second detents (10, 11) on the cover (1) are disposed at a clear first distance (a) from each other in the direction of the longitudi-nal axis (12) of the lead sealing pin (6) and in that the transverse distance (h) between these detents (10, 11) measured in the transverse direction of the longitudinal axis (12) of the lead sealing pin (6) is smaller than the length (L) of the flange (5), and in that the clear first distance (a) is greater than or equal to the thickness (d) of the flange (5) and in that the clear second distance (c) between the large locking bar (8) and the second detent which is farther removed from the large locking bar (8) is less than or equal to the length (l) of the lead sealing pin (6).

2. A means according to claim 1, characterised in that, measured in the transverse direction in relation to the longitudinal axis (12) of the lead sealing pin, the transverse distance (h) between the first (10) and the second detent (11) is not more than approximately equal to the length (L) of the flange (5).

3. A means according to claim 1 or 2, characterised in that in a plane parallel with the main plane of the large locking bar (8) and displaced in the direction of the first detent (11), a small locking bar (9) is disposed at a clear third distance (e') from the large locking bar (8) and is fixed on the cover (1) and in that the clear third distance (e') is at least equal to the thickness (d) of the flange (5) and in that preferably in each of the two locking bars (8, 9) there is one hole (13', 13'') aligned with the other, a further hole (13) provided in the flange (5) of the lead sealing pin (6) being adjustable to align with these holes (13', 13'').

4. A means according to one of claims 1 to 3, characterised in that the locking bars (8, 9), the lead sealing pin (6), the flange (5) and the lead sealing lug (4) of the appliance frame are disposed substantially in a depression (2) in the cover (1).

5. A means according to one of claims 1 to 4, characterised in that the flange (5) is fixed eccentrically on the lead sealing pin and is preferably elongate in construction.

6. A means according to claim 5, characterised in that the eccentric flange (5) has an abutment face (18) for engagement with a surface of the depression (2).

7. A means according to claim 5 or 6, characterised in that the eccentric flange (5) has, facing the observer and in a countersunk position, an undercut or groove (15) or other facility for the engagement of a tool.

8. A means according to one of claims 5 to 7, characterised in that the eccentric flange (5) has a knurled surface (16) or other form of superficial roughness.

9. A means according to one of claims 1 to 8, characterised in that the clear fourth distance between the large locking bar (8) and the nearest detent (10) is greater than the thickness (d) of the flange (5).

## Revendications

1. Dispositif pour assurer simultanément le scellement et le verrouillage mécanique d'un couvercle (1) sur le bâti d'un appareil, en particulier un sectionneur, une semelle ou une réglette de connexion d'un coupecircuit basse tension à haut pouvoir de coupure, dispositif dans lequel une cheville de scellement (6), guidée de façon à pouvoir coulisser par rapport au couvercle (1) dans le trou aménagé dans une grande traverse de blocage (8), cheville comportant en l'une de ses extrémités une collerette (5), peut être insérée dans le trou d'une languette de scellement (4) fixée au bâti de l'appareil, et a un diamètre inférieur à la longueur (L) de la collerette (5), caractérisé en ce qu'un premier et un deuxième tenons à cran d'arrêt (10, 11) sont rapportés au couvercle (1), en faisant l'un avec l'autre un premier écartement (a) dans la direction de l'axe longitudinal (12) de la cheville de scellement (6) ; que la distance transversale (h) de ces tenons à cran d'arrêt (10, 11), mesurée dans la direction transversale par rapport à l'axe longitudinal (12) de la tige de scellement (6), est inférieure à la longueur (L) de la collerette (5) ; que le premier écartement (a) est supérieur ou égal à l'épaisseur (d) de la collerette (5) ; et que le deuxième écartement (c) entre le deuxième tenon à cran d'arrêt, qui est plus éloigné de la grande traverse de blocage (8), et la grande traverse de blocage (8), est inférieur ou égal à la longueur (1) de la cheville de scellement (6).

2. Dispositif selon la revendication 1, caractérisé en ce que la distance transversale (h), mesurée dans la direction transversale par rapport à l'axe longitudinal (12) de la cheville de scellement (6) entre le premier tenon à cran d'arrêt (10) et le deuxième tenon à cran d'arrêt (11), est au plus approximativement égale à la longueur (L) de la collerette (5).

3. Dispositif selon la revendication 1 ou 2, caractérisé en ce que, dans un plan parallèle au plan principal de la grande traverse de blocage (8), et décalée dans le direction du premier tenon à cran d'arrêt (10), une petite traverse de blocage (9) est disposée à un troisième écartement (e') de la grande traverse de blocage (8) et est fixée au couvercle (1) ; que le troisième écartament (e') est au moins égal à l'épaisseur (d) de la collerette (5) ; et que, de préférence, dans chacune des deux traverses de blocage (8, 9) est rapporté un trou (13', 13''), les deux trous étant en alignement l'un par rapport à l'autre, un autre trou (13), présent dans la collerette (5) de la cheville de scellement (6), pouvant être ajusté de façon à être en alignement avec ces trous (13', 13'').

4. Dispositif selon l'une des revendications 1 à 3, caractérisé en ce que les traverses de blocage (8, 9), la cheville de scellement (6) la collerette (5) et la languette de blocage (4) du bâti de l'appareil sont essentiellement disposées dans un évidement (2) aménagé dans le couvercle (1).

5. Dispositif selon l'une des revendications 1 à 4, caractérisé en ce que la collerette (5) est fixée d'une manière excentrée à la cheville de scellement (6) et est de préférence conçue d'une manière oblongue.

6. Dispositif selon la revendication 5, caractérisé en ce que la collerette excentrée (5) présente une surface de butée (18) destinée à permettre une prise avec une surface de l'évidement (2).

7. Dispositif selon la revendication 5 ou 6, caractérisé en ce que la collerette excentrée (5) présente une contre-dépouille ou une gorge (15), ou une autre possibilité de prise pour un outil, dirigée, en position renfoncée, vers l'observateur.

8. Dispositif selon l'une des revendications 5 à 7, caractérisé en ce que la collerette excentrée (5) présente des cannelures (16) ou une autre rugosité superficielle.

9. Dispositif selon l'une des revendications 1 à 8, caractérisé en ce que le quatrième écartement entre la grande traverse de blocage (8) et le tenon à cran d'arrêt (10) situé le plus près de cette dernière est supérieur à l'épaisseur (d) de la collerette (5).
